# EUROPEAN PATENT APPLICATION

(11) **EP 2 725 309 A1**
(43) Date of publication of application: **30.04.2014**
(21) Application number: 13189559.1
(22) Date of filing: 21.10.2013
(51) Int. Cl.: F24J 2/52, H01L 31/042

(54) **Structure for the installation of photovoltaic panels on roofs or facades of buildings, with air cooling and possible recovery of thermal energy**

(30) Priority: 23.10.2012 IT BO20120575
(71) Applicant: TEROM S.P.A., I-40050 Funo BO (IT)
(72) Inventor: Romoli, Piero, 40122 Bologna (IT)
(74) Representative: Porsia, Attilio

(57) **Abstract**

Structure for installing photovoltaic panels on the roofs or walls of buildings with air cooling and coverage provided by said structure, of the type comprising metal base profiles (1) for fixing to the roof, perpendicular to the ridge and/or eaves lines, parallel to one another and such as to support with interposed seals (7, 7') coplanar panels (FV) connected sealingly to one another by suitable joining means and fixed on said base profiles by means of metal covering profiles (9), in which the profiles supporting the panels (FV) comprise base profiles (1) made of extruded aluminium, designed for fixing at the bottom cross members (2) which, with their ends, project on either side of said profiles and which with the same ends are fixed with adjustable height positioning, by means of nuts (103), on stud bolts (3) secured in a suitable way to the pitch (F) of the roof, so that said base profiles (1) can form a supporting frame; it is possible to accurately adjust both the longitudinal and transverse flatness, also in the presence of significant imperfections in the pitch (F) below, and to create below the photovoltaic panels (FV) an empty space with the height necessary each time for the formation of said aeration chamber (CA) and to position below this and on the pitch (F) at least one layer of panels (16) for the thermal insulation of the pitch necessary each time, it being envisaged that at least a part of said cross members (2) can rest or if necessary be anchored, directly or indirectly, on said thermal insulation panels (16) below, to improve the load-bearing characteristics of the structure in question.

## Description

The invention concerns a structure for installing, on roofs or facades of buildings, photovoltaic panels (referred to below for the sake of brevity by the abbreviation FV), with air cooling and with recovery of thermal energy. In particular the structure in question is suited to the coplanar installation of thin film glass-glass type latest generation FV panels, currently without metal stiffening and support frame. As state of the art known and closest to the invention, in the international classes of interest E04D, H01L, F24J, the publications of the following patent applications are cited: EP 905 795 published in March 1999; DE 101 36 037 published in March 2003; EP 2 023 402 published in February 2009; FR 2 962 798 published in July 2010; WO 2010/094781 published in August 2010; FR 2 944 817 and EP 2 239 783 published in October 2010; WO 2010/128473 published in November 2010; FR 2 961 299 published in December 2011. In all the solutions of known type, particularly if intended for total integration in the roof, the metal profiles perpendicular to the ridge line, on which the opposite sides of the FV panels are rested and are then fixed throughout their length with other extruded covering profiles and with interposed seals, are currently anchored to the pitch of the roof, directly or by the interposition of other metal profiles, resulting in the following technical problems: **a)** the laying surface of the roof may not be perfectly flat, and is often markedly irregular, with consequent aesthetic problems and difficulty in laying the FV panels in a sealing manner; **b)** when thermal insulation panels are laid on the roof, to form between these and the FV panels a chamber for the circulation of air for cooling the FV panels and for recovering thermal energy if necessary, said thermal insulation panels are interrupted at said FV panel supporting profiles, with consequent formation of thermal bridges concentrated on said profiles and with resulting problems of expansion and deformation. In an attempt to remedy this latter drawback, in the prior document WO 2010/094781 the longitudinal profiles are fixed to a further base profile, fixed on the pitch of the roof, with the interposition of polyamide bars which interrupt said thermal bridge. This solution is costly and does not fully solve the problem since the circulation of cooling air is prevented throughout the lower surface of the longitudinal profiles supporting the panels.

The following prior documents are also cited as known state of the art: WO 2011/ 066 843; DE 2005 039495; JP 2002/013265; JP 2011/246896 and JP 2002/038662.

Again, these documents do not illustrate how it is possible to produce a photovoltaic panel support in a condition of substantial coplanarity, with the possibility of accurately adjusting the flatness of said structure, both parallel and perpendicular to the direction of the ridge and with high resistance to the bending and torsional stress of the continuous profiles perpendicular to the ridge which compose said supporting structure.

The invention aims to remedy these and other problems of the known art, with the solutions described in the attached claim 1) and relative dependent claims, the characteristics and advantages of which will appear evident from the following description of a preferred embodiment of the same, illustrated purely by way of nonlimiting example, in the figures of the four accompanying drawings, in which:
- Fig. 1 is a lateral and perspective view of one of the pairs of longitudinal profiles which usually sustain FV panels on their opposite sides but which in this case sustain FV panels on one side only, while they are illustrated free on the opposite side to better highlight the parts that sustain them, the parts which they themselves sustain and those that complete them;
- Fig. 2 illustrates the longitudinal profiles of figure 1 cross-sectioned along the line II-II;
- Fig. 3 illustrates details of the solution used for the reciprocal seal connection of the sides of the FV panels parallel to the ridge line of the roof;
- Fig. 4 and 5 illustrate, in perspective and with parts exploded, the ends of the pairs of longitudinal profiles according to the preceding figures, respectively the end corresponding to the eaves and the one corresponding to the ridge of the roof;
- Fig. 6 is a plan view of one of the plates used to fix components to the longitudinal lower groove of the main longitudinal profiles according to the preceding figures;
- Fig. 7 illustrates the ridge area of a gable roof, both sides of which are provided with a structure of the type for the support of FV panels;
- Fig. 8 is a perspective view, shown from the direction indicated by the arrow K of figure 1, of the joining area of one of the pairs of longitudinal profiles supporting the panels with the ridge closing structure.

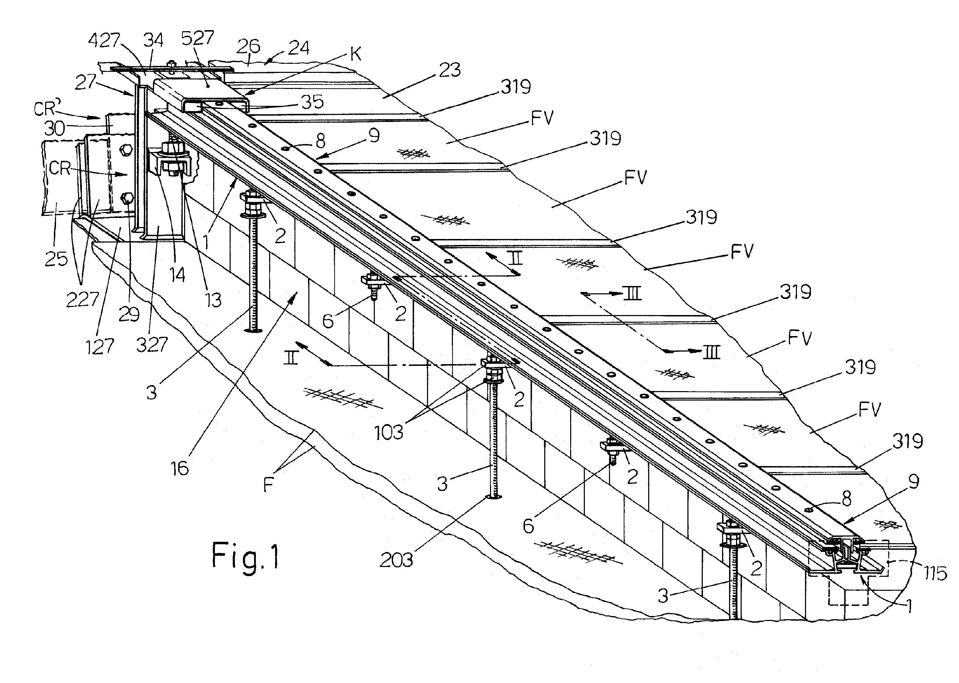

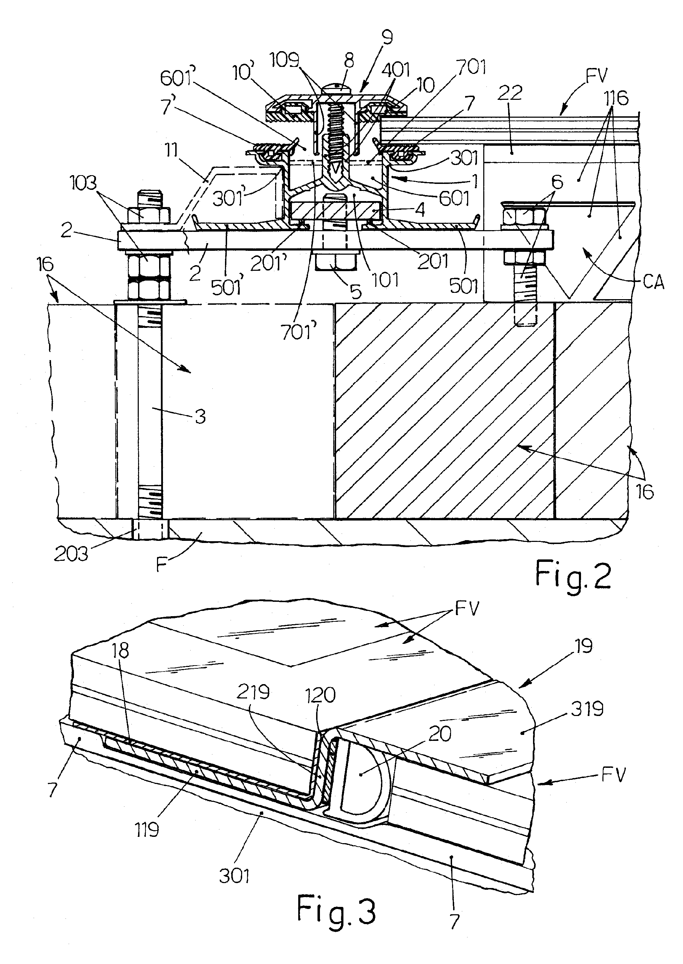

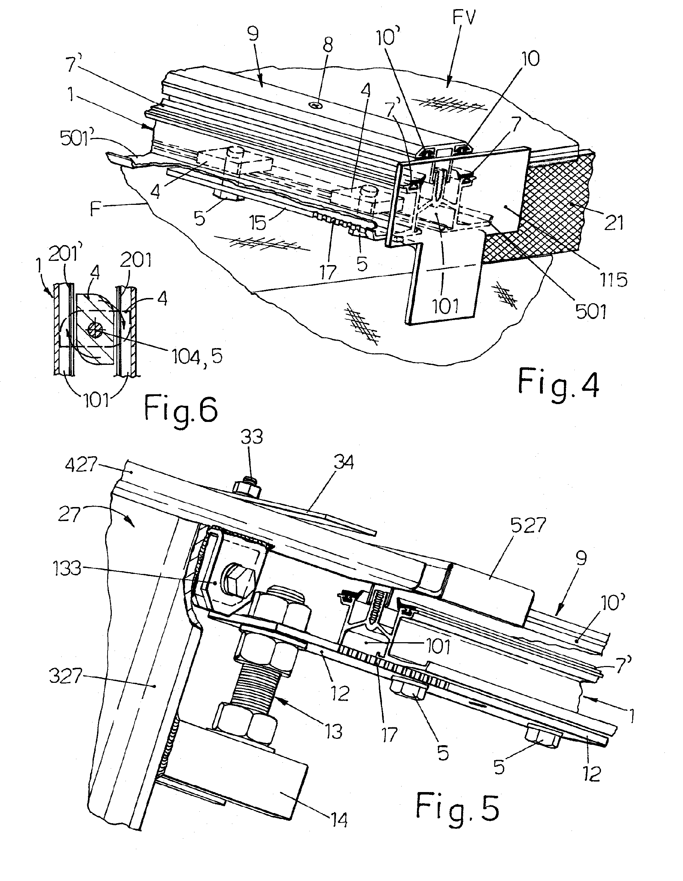

From figures 1 and 2 it can be seen that extruded aluminium profiles 1 are fixed on each pitch F of the roof perpendicular to the eaves side of the roof, parallel to one another, with a distance correlated to the dimensions of the FV panels and in such a way as to involve the pitch itself substantially throughout its inclined extension; said profiles are installed by means of a solution that allows adjustable distant positioning from the pitch F, in order to provide on the latter a layer of thermal insulation (see below) of appropriate thickness to meet the various construction needs and to accurately adjust the flatness of the overall framework formed by said profiles 1, also in the presence of slight or significant errors in flatness and/or inclination or horizontality, therefore both vertical and horizontal, of the entire pitch . For this purpose, on the lower part of the profiles 1, cross members 2 are fixed in a sufficient quantity, made of any suitable material, **also with characteristics of thermal insulation,** with ends projecting laterally from both sides of the profile 1 and provided with respective holes so that they can be fastened in an adjustable manner, with nuts 103 and/or other suitable means, on stud bolts 3 fixed perpendicular to the pitch F of the roof, for example with the aid of chemical or expansion bolts 203, which if made of polymeric material can also contribute to interrupting the thermal bridge in the system for fastening the profiles 1 to the pitch F. From figures 1 and 2 it can be seen that, due to the projection of the ends of the cross members 2 from the sides of the profiles 1, it is possible to accurately and easily adjust both the longitudinal flatness and the transverse flatness of the various profiles 1 that form the supporting structure of the FV panels, with said profiles 1 mounted and fixed on said cross members 2. By raising or lowering to an equal extent the nuts 103 of each pair of stud bolts 3, the cross member 2 with adjacent profile 1 is raised or lowered, without modifying the transverse set-up of the complex 1, 2. If, on the other hand, the height of one or both the nuts 103 of each pair of stud bolts 3 is adjusted to a different extent, in addition to modifying the height of the complex 1, 2, also the transverse set-up of said complex is modified in an evident manner. From the same figures 1 and 2 it can also be seen that due to the portal configuration of the groups of stud bolts 3 with the relative cross members 2, the profiles 1 are sustained with great resistance to mechanical stress, both longitudinal and transverse, and also to bending and torsional stress, with the considerable advantages deriving from the possibility of progressive installation of the FV panels also by one single operator, with laying of the panels in succession between the nearby pairs of profiles 1, and of securely sustaining, and without distribution of the stresses on the FV panels, the load of any persons on said profiles 1 during inspection of the photovoltaic roof. For the above purposes, the profiles 1 are provided at the bottom with a longitudinal and median groove 101, with C-shaped section C, open towards the bottom, in which plates 4 with a hammer plan shape can be inserted as shown in figure 6, having width narrower than the mouth of the groove 101 and provided in the centre with a threaded hole 104 in which it is possible to tighten a screw 5 which crosses a median hole of said cross members 2. When the screw 5 is tightened, the plate 4 passes from the position illustrated in figure 6 with continuous line to the one illustrated with broken line, transversally engaging the groove 101 of the profile 1 and the lips of the mouth of said groove are clamped between said plate 4 and the cross member 2. It is understood that the screw 5 can alternatively be integral with the head at the plate 4 and that at least one nut can be tightened at its threaded end which projects from the hole of the cross member 2. Advantageously, the lips of the groove 101 are provided internally with longitudinal ribs 201, 201' into which the plates 4 can be driven, thus being securely fixed to the profile 1. From figures 1 and 2 it can be seen that some cross members 2 may not be fixed to the pitch F and with the head of bolts 6 fixed to their end holes, they can be rested and anchored directly, or with the interposition of any load distribution structures, to the mats of thermal insulation material 16 (see below) which are then laid on the pitch F, so as to distribute also on said mats any future mechanical stress on the profiles 1 and on the FV panels which may be caused by the weight of snow and/or footfall of maintenance personnel. After installation of the main profiles 1, a relative part of said thermal insulation material 16 may be laid below said profiles; said material will rest at the bottom on the pitch F, which will incorporate the stud bolts 3 and which at the top may be at a sufficient distance from the cross members 2 or may touch at the bottom said cross members or the profiles 1, in a continuous or discontinuous manner. From the detail of figure 2 it can be seen that the profiles 1 are provided laterally with symmetrical specular wings 301, 301' which extend upwards, which act as a bracket and are provided at the top with longitudinal grooves to contain elastomeric gaskets 7, 7' on which the sides of the FV panels will rest sealingly. The same profile 1 is provided between the wings 301, 301' with a longitudinal and median groove 401 open towards the top and with the inner walls longitudinally ribbed, which acts as a seat for the tightening of self-tapping screws 8 useful for the installation of a covering profile 9, also made of extruded aluminium, provided at the bottom with a longitudinal and median groove 109 which couples with and centres externally on said groove 401 of the lower profile 1 and which in turn is provided on the sides with longitudinal grooves open towards the bottom, to house gaskets 10, 10' suited to cooperate sealingly with the upper part of the sides of the FV panels, contrasting the lower gaskets 7, 7', thus ensuring a seal coupling of said FV panels with the longitudinal profiles 1 and 9. From figure 2 it appears evident that the clamping space of the FV panels between the gaskets 10, 10' and 7, 7' is characterised by sufficient transverse play which ensures a corresponding considerable freedom of transverse expansion of the entire structure formed of the FV panels and relative pairs of support profiles 1, 9. The lower profile 1 is completed by large base wings 501, 501' which rest on the cross members 2 and which have their free edge raised to act as gutters, useful for channelling and discharging to the eaves line any water infiltrations through the lower gaskets 7, 7'. From figure 2 it can be seen that the screws 8 are of a length such as not to perforate the bottom of the groove 401 which in this way can also act as a gutter to channel downwards any slight infiltrations of water between said screws 8 and the holes crossed by the latter on the covering profile 9. Any slight infiltrations of water through the upper gaskets 10, 10' can be readily collected and channelled downwards by the longitudinal grooves 601, 601' existing on the outer sides of the median groove 401. It is understood that the profiles 1 and 9 as illustrated in the drawings can be replaced by commercial profiles having at least equivalent characteristics and that said profiles can be perfected to improve their load-bearing characteristics. For this purpose, for example, the profile 1 can be provided with upper ribs 701, 701' which connect the wings 301, 301' to each other and to the walls of the median groove 401, as illustrated in figure 2 by the broken line, said ribs being positioned at a lower level with respect to the gaskets 7, 7' so as to form with the latter, albeit with a limited size, said grooves 601, 601' useful for the collection and channelling downwards of any slight infiltrations of water through the gaskets 7, 7'. Again to increase the load-bearing characteristics of the profile 1, alternatively to or in combination with the presence of said ribs 701, 701', brackets 11 can be used with a reverse hook profile (a single one of these is illustrated in figure 2 with broken line), provided at the flat end with a hole so that they can be fixed on the ends of the cross members 2 by means of the stud bolts 3 and relative nuts 103 and which with the other end are arranged in contact with the outer lateral surface of the sides of the profile 1 or at least between the upper part of the wings 301, 301' and the base wings 501, 501', in a manner which is intuitive for and can be easily implemented by persons skilled in the art. The materials that make up all the accessory parts described so far will be such as to avoid phenomena of galvanic corrosion in the contact with the aluminium profiles, hence said parts can be made of stainless steel or be coated in plastic or ceramic materials or other materials useful for the purpose. To give greater stability and safety to installation of the profiles 1, considering that their longitudinal inclination and the weight that will rest on them and that the consequent force of gravity will tend to push said profiles towards the eaves line of the roof, on the upper end of each profile 1 (see figure 5) a stainless steel longitudinal plate 12 is fixed to the longitudinal, median and lower groove 101 thereof, with screws 5 and with internal plates 4 of the same type as those used for fixing the cross members 2; the end of said plate projecting from the profile 1 bears at least one hole for anchoring in an adjustable manner to a bolt 13 integral with a bracket 14 fixed to a bridge structure 27, in turn fixed on the roof ridge and which will be described further on. The photovoltaic panels FV are rested on the opposite wings 301, 301' of the profiles 1 starting from the eaves line, hence means are provided to sustain between each pair of profiles 1 the FV panel which is laid first and to ensure that the latter then temporarily sustains the successive panel and so on, until the last FV panel is laid near to the ridge line of the roof. To sustain the panel which is laid first and to prevent it slipping downwards, a stainless steel plate 15 is fixed on the eaves end of the profiles 1 (see fig. 4), to the lower and median groove 101 thereof, with screws 5 and plates 4 of the same type as those used for fixing said cross members 2; said plate bears integrally and arranged perpendicularly on its projecting end an appendix 115 having for example a T shape or any shape suitable for resting the horizontal side both of the photovoltaic panels FV which are positioned first on the profiles 1 and of the thermal insulating material 16 which will be laid on the pitch F of the roof and which will be described further on, preferably with the interposition of a target grille 21 (see below). From figures 4 and 5 it can be seen that the plates 12 and 15 can be provided laterally with reference notches 17 for example with decimal pitch, useful to facilitate correct installation of said plates, using the ends of the profiles 1 as a target and reference line.

To ensure reciprocal connection in a sealing manner of the horizontal sides of the photovoltaic panels FV, the following means are provided now described with reference to figures 1 and 3. Throughout the front horizontal side of each second FV panel and of those that will follow it starting from the eaves line of the roof, the lower wing 119 and the intermediate and consecutive part 219 of a Z shaped profile 19, for example made of stainless steel and/or other appropriate material suited to the uses in question, is fixed with material 18 having the function of both sealing agent and adhesive; the upper wing 319 of said profile is arranged above the FV panel positioned below, having the function of a tile. On the intermediate side 219 of the profile 19, a tubular gasket 20 is fixed with its own or an additional adhesive 120; said gasket is made of any suitable elastomeric material which, unlike the illustration of figure 3, is compressed and provides a perfect air and water seal between the profile 19 and the lower FV panel, also permitting the recovery of slight errors in laying of the FV panels and relative support means. The strip of material from which the profile 19 is obtained has a limited thickness, for example approximately 1 mm, so that the horizontal joining areas between the FV panels can be clamped to provide a seal between the gaskets 7, 10 and 7', 10' of the pairs of support profiles 1, 9. From what has been described and illustrated, it is evident that the structure in question for support of the FV panels allows free expansion of all its components in both a longitudinal and transverse direction, with the great resulting advantages of reliability and safety.

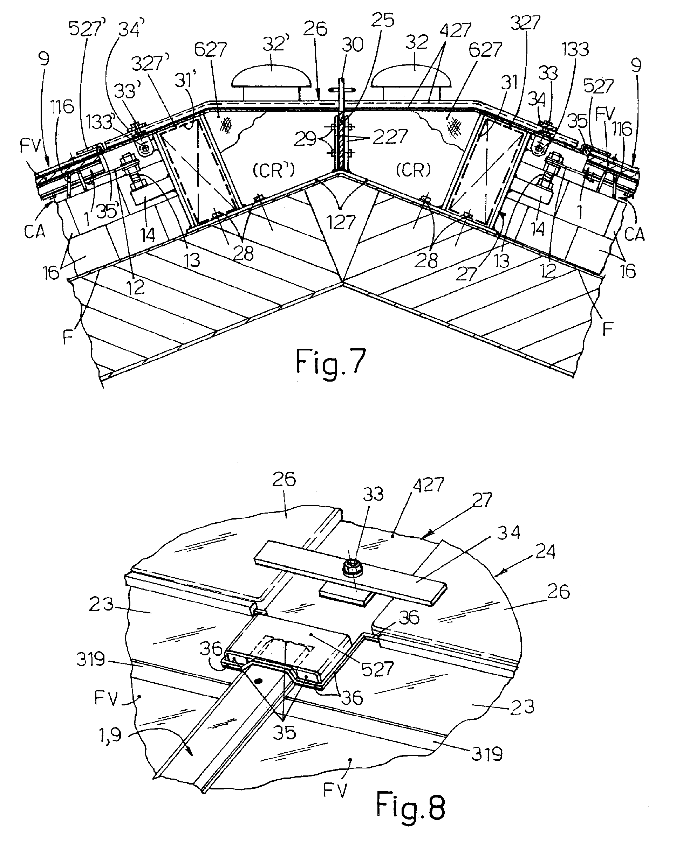

From figures 1, 2, 4 and 7 it can be seen that the spaces defined laterally by the stud bolts 3 supporting the base profiles 1, at the bottom by the pitch F and at the top by the panels FV, are preferably engaged only for part of their height by one or more layers of panels 16 of thermo-insulating material, for example made of foamed polyurethane or in extruded polystyrene, with high density, above which an aeration chamber CA forms useful for removing heat from said FV panels and for improving electrical efficiency also in the presence of strong solar radiation, said air being sucked for said purpose through grilles 21 located at the eaves of the roof (fig. 4) and the air being discharged via a suitable chimney configuration of a covering structure 24 of the roof ridge (fig. 1, 7) , with a solution illustrated further on. Below the insulation panels 16 a steam barrier can be positioned, not illustrated, and the upper part of said panels 16, or at least of those of the layer next to the FV panels, can be coated with any material with intrinsic qualities and colour suited to collect the heat coming from said FV panels and from the solar radiation and which can be shaped to increase the thermal exchange surface with the cooling air. The panels 16 next to the FV panels are associated at the top, as an integral or fill part, to truss or perforated beams 116, which engage the aeration chamber CA transversally without obstructing the circulation of the air therein, which are made of any suitable mechanically resistant material, for example metal, and which have dimensions such as to touch, preferably with interposed inserts 22 made of a suitable elastomeric material, the lower face of the FV panels, to make the latter more resistant to the mechanical stress caused for example by snow, ice or footfall of the maintenance personnel who, with suitable precautions, must be able to walk over the structure in question.

From figures 1, 5, 7 and 8 it can be seen that at the roof ridge, between each pair of clamping profiles 1 and 9, a metal sheet 23 is positioned, for example made of stainless or weathering (COR-TEN) steel, which with the same supporting profiles enters the structure 24 covering the roof ridge and which will be fixed sealingly to the horizontal side of the last FV panel with a gasket of the type shown by 20 in figure 3 or by means of sealing of the profiled side of said sheet 23 to the FV panel, with a polymer or silicone adhesive, for example. The ridge structure 24 is designed so as to create an aeration chamber which runs all along the ridge of the roof and which is divided into two halves CR, CR', one per pitch, by vertical and median partitions 25 (fig. 1, 7) parallel to the line of said ridge. The chambers CR, CR' are closed at the top by covers 26 made of bent sheet metal (stainless steel or other suitable materials), of length equal to the width of an FV panel and also aligned in the direction of the ridge. Between the covers 26 and partly below them, in order to sustain them, metal bridges 27 are provided which comprise:
- base profiles 127 which have the same angle of inclination as the pitches F of the roof, which rest on the latter and which are fixed to the same by means of screws 28 tightened in corresponding seats of chemical bolts anchored to said pitches. At the centre line of the ridge, said bases 127 bear integrally pairs of vertical opposed plates 227 which with their opposite end portions are used as guides to sustain in the manner of a drawer said vertical partitions 25 and to an intermediate portion of which brackets 30 can be fixed, via means 29; said brackets can project sealingly from every bridge 27 (see below) to support the steel cable of a life line to which the operators can connect the snap hooks of their safety harness;
- on the ends of said base profiles 127, double T uprights 327, 327' are fixed perpendicularly, to which the brackets 14 are welded with the anchoring bolts 13 of the upper end of the profiles 1, 9 which support the FV panels. The ends of heat exchangers 31, 31' of the air-liquid type can be fixed to said uprights 327, 327', said heat exchangers being indicated by a broken line, parallel to the ridge so that they can be crossed by the hot air which comes out of the cooling chambers CA below the FV panels and which flows into the upper chambers CR, CR' from which it will then exit via discharge chimneys 32, 32' positioned on covering elements 26 described further on and if necessary provided with electric fans (not illustrated) to extract air from said chambers CA to be cooled. Said electric fans will be operated by a control system which receives input for example relative to the temperature of the cooling air of the FV panels and to the temperature of the liquid circulating in the heat exchangers 31, 31'. Said control system starts and regulates also the pumps for circulation of the liquid in the radiators 31, 31' according to the temperature desired in the heat exchange system boiler, not illustrated. It is understood that the heat recovered via the heat exchangers 31, 31' can be used for any purpose, either to produce hot water or for internal conditioning of the building via heat pumps;

- an upper wall 427 fixed to the top of the uprights 327, 327', counter to the base structure 127, provided with a horizontal walkable intermediate section and characterised by a U-shaped transverse profile, so that its raised edges can be surmounted by the corresponding end edges bent towards the bottom of the ridge covers 26. The upper wall 427 is provided halfway and on the centre line with a slot crossed sealingly by the bracket 30 of the life line and the same wall 427 is provided at the ends and again on the centre line with holes crossed sealingly by screws 33, 33' integral with forks 133, 133' anchored to the upper part of the double T uprights 327, 327' and cross members 34, 34' are fixed to said screws 33, 33' by respective nuts; as illustrated in figure 8, said cross members can be tightened to form a bridge between the consecutive covers 26 of the ridge, to lock them securely in place. Rotating the cross members 34, 34' perpendicular to the ridge line, it is possible to remove the covers 26 and access the inside of the ridge cover 24;
- at the ends of said upper wall 427, small pantiles 527, 527' are obtained by cutting and bending operations or are welded; said tiles surmount the upper ends of the pairs of profiles 1, 9 supporting the FV panels and are closed by insulation and sealing inserts 35, 35'. The pantiles 527, 527' are arranged above the upper plates 23 connecting the FV panels with the ridge covering 24 and the area in which the parts 427, 26, 527, 527', 35, 35' join is closed sealingly by a course of putty or sealing agent 36 which prevents infiltration of water both downwards and upwards.

The area between the base profiles 127 and the upper wall 427 of every bridge 27 is preferably closed by a transverse wall 627 (fig. 7) to improve the resistance of said bridges 27 to footfall and to prevent the air flows which come from each chamber CA and which, through the heat exchangers 31, 31' reach the upper chambers CR, CR', from interfering with one another. It follows that the chambers CR, CR' are formed of several sections of chambers positioned one following the other, divided from one another by a respective wall 627, each of which is closed by a cover 26 with relative discharge chimneys 32, 32' and each of which communicates with a cooling chamber CA.

It is evident that the system described can be mounted on any type of roof, with easy adaptation to any range of distances from the structural surface and with the possibility of installing any type of insulating material 16, as needed and according to the thicknesses required. The same system is self-supporting and can adapt in a distributed manner to the thermal expansion of the various components, thanks to the elastic play between the FV panels and the relative pairs of support profiles 1, 9 and between the FV panels themselves. The scope of the invention also includes the variations relative to the covering of one single pitch of a roof or very inclined or even vertical wall surfaces. The details relative to the electrical connections of the FV panels and the hydraulic connections of the heat exchangers 31, 31' have been omitted from the description, since they are intuitive for and can be easily implemented by persons skilled in the art. The details relative to the finish of the areas joining the structure in question to the lateral parts and to the roof eaves have also been omitted, as they can be configured in any way to adapt to any architectural requirement for covering of the roof, if necessary also for cases in which the partial use of traditional pantiles or tiles is scheduled. It is therefore understood that numerous construction modifications can be made to the invention, moreover without abandoning the informing principle of the invention, as described, illustrated and as claimed below. In the claims, the references given in brackets are purely indicative and do not limit the protective scope of said claims.

## Claims

1. Structure for installing photovoltaic panels on the roofs or walls of buildings with air cooling and coverage provided by said structure, of the type comprising metal base profiles (1) for fixing to the roof, perpendicular to the ridge and/or eaves lines, parallel to one another and such as to support with interposed seals (7, 7') coplanar panels (FV) connected sealingly to one another by suitable joining means and fixed on said base profiles by means of metal covering profiles (9) and with other relative seals (10, 10'), interposed to form a waterproof and windproof cover and of the type in which below the panels (FV) and between the pairs of said support profiles (1, 9), aeration chambers (CA) are provided with the lower end open at the level of the eaves line of the roof, for inlet of the atmospheric air, and with the upper end open below a chimney cover (24) of the roof ridge, so that the heat produced by the solar radiation on the panels (FV) can be removed by the flow of air which in a natural or forced manner crosses said aeration chambers (CA) and is discharged in said chimney cover of the roof ridge, **characterised in that** said profiles supporting the panels (FV) comprise base profiles (1) made of extruded aluminium, designed for fixing at the bottom cross members (2) which, with their ends, project on either side of said profiles and which with the same ends are fixed with adjustable height positioning, by means of nuts (103), on stud bolts (3) secured in a suitable way to the pitch (F) of the roof, so that said base profiles (1) can form a supporting frame; it is possible to accurately adjust both the longitudinal and transverse flatness, also in the presence of significant imperfections in the pitch (F) below, and to create below the photovoltaic panels (FV) an empty space with the height necessary each time for the formation of said aeration chamber (CA) and to position below this and on the pitch (F) at least one layer of panels (16) for the thermal insulation of the pitch necessary each time, it being envisaged that at least a part of said cross members (2) can rest or if necessary be anchored, directly or indirectly, on said thermal insulation panels (16) below, to improve the load-bearing characteristics of the structure in question.

2. Structure as claimed in claim 1), wherein said stud bolts (3) are fixed to the pitch of the roof with inserts (203) made of polymeric material and alternatively to or in combination with this, said cross members (2) can be made of or coated with thermal insulating material, so as to interrupt the thermal bridges which would otherwise discharge onto the pitch (F) of the roof the thermal energy involving the pairs of metal profiles (1, 9) supporting the photovoltaic panels (FV).

3. Structure as claimed in claim 1), wherein the base profiles (1) are of the type which comprise: at least one longitudinal and lower groove (101) with mouth open downwards, for fixing said cross members (2) below said profiles (1) and for fixing other components on the ends of said profiles (1); large base wings (501, 501') with concave upward profile, useful both as base supports and as gutters for the collection and discharge of slight infiltrations of water; two robust side wings (301, 301') with grooves for housing seals (7, 7') on which the photovoltaic panels (FV) rest; a longitudinal and median groove (401), open towards the top, positioned symmetrically between said wings (301, 301') and the inner surface of which is provided with longitudinal ribs for the tightening of self-tapping screws (8) via which the median centring groove (109) is fixed to said groove (401) and open towards the bottom of the covering profile (9) which with its wings bears at the bottom the gaskets (10, 10') for cooperation in a sealing manner with the photovoltaic panels (FV), said groove (401) not being perforated at the bottom by said screws (8), thus acting as a gutter; grooves having the function of a gutter (601, 601') positioned between said wings (301, 301') and said median groove (401); reinforcement means if necessary (701, 701' and/or 11).

4. Structure as claimed in claim 3), wherein the spaces between the wings with gaskets (7, 7') of the lower profile (1) and the wings with gaskets (10, 10') of the upper profile (9) contain the sides of the photovoltaic panels (FV) with ample transverse play to allow said panels (FV) to expand extensively also in the transverse direction.

5. Structure as claimed in claim 1), wherein throughout the front horizontal side of each second photovoltaic panel (FV) and of those that will follow it starting from the eaves line of the roof, the lower wing (119) and the intermediate and consecutive part (219) of a Z-shaped profile (19), made of stainless steel or other material suited to the uses in question, are fixed with material (18) having the function of sealing agent and/or adhesive; the upper wing (319) is arranged above the lower panel (FV), having the function of a tile; on the intermediate side (219) of said profile (19), fastened with its own or additional adhesive (120), is a gasket (20) made of any suitable elastomeric material which provides a perfect air and water seal between the profile (19) and the lower panel (FV), also allowing the recovery of slight errors in laying of the panels (FV) and relative support means.

6. Structure as claimed in claim 5), wherein the strip of material from which said profile (19) is obtained has a limited thickness, for example approximately 1 mm, so that the horizontal joining areas between the photovoltaic panels (FV) can be clamped sealingly between the gaskets (7, 10 and 7', 10') of the pairs of profiles (1, 9) supporting said panels (FV).

7. Structure as claimed in claim 3), wherein at the upper end of each base profile (1) a stainless steel longitudinal plate (12) is fixed to its longitudinal and lower groove (101), with screws (5) and with inner plates (4) similar to those used for fixing said cross members (2) to the same profile (1); the edge of said plate projecting from the profile (1) has at least one hole to be anchored in an adjustable manner to a bolt (13) integral with a bracket (14) secured to a bridge structure (27) which is fixed on the ridge of the roof; furthermore, on the eaves end of said base profiles (1), a stainless steel longitudinal plate (15) is fixed to the longitudinal and lower groove thereof (101) by means of screws (5) and plates (4) similar to those used for installation of said cross members (2); the projecting end of said longitudinal plate bears integrally and with transverse arrangement an appendix (115) having any form suitable for resting thereon the horizontal side both of the photovoltaic panels (FV) which are positioned first on the base profiles (1) and of the thermal insulating material (16) which will be positioned on the pitch (F) of the roof, said plates (12, 15) being provided on the sides with reference notches (17) if necessary, useful for facilitating correct installation of said plates (12, 15).

8. Structure as claimed in claim 1), wherein the thermal insulation panels (16) next to the photovoltaic panels (FV) are associated at the top, as an integral or fill part, to truss or perforated beams (116), which transversally engage the aeration chamber (CA) without obstructing the circulation of the air therein; said beams are made of any suitable mechanically resistant material and have dimensions such as to touch, with interposed inserts (22) of elastomeric material, the lower face of the photovoltaic panels (FV) to make the latter more resistant to the mechanical stress caused for example by snow, ice or footfall of maintenance personnel.

9. Structure as claimed in claim 7), wherein the metallic bridges (27) fixed transversally on the roof ridge comprise: - base profiles (127) which rest on the pitches (F) of the roof, are fixed to the latter by means of screws and inserts (28) and at the centre line of the ridge bear integrally pairs of vertical plates (227) in which the ends of vertical partitions (25) are inserted in the manner of a drawer, splitting into two parts (CR, CR') the chamber of the ridge into which said aeration chambers (CA) below the panels (FV) flow, if necessary brackets (30) being fixed by screws (29) to an intermediate portion of said parallel plates (227); said brackets can project from each bridge (27) to support the steel cable of the life line to which the operators can anchor with the snap hooks of their safety harness; - the ends of said base profiles (127) are fitted with double T uprights (327, 327') to which the brackets (14) with the adjustable anchoring bolts (13) of the upper end of the base profiles (1) supporting the panels (FV) are welded; the ends of air-liquid type heat exchangers (31, 31') can be fixed to said uprights (327, 327'), said exchangers being parallel to the ridge and such as to be crossed by the hot air which comes out of the cooling chambers (CA) below the panels (FV) and which flows into the upper chambers ( CR, CR') from which it will then exit through discharge chimneys (32, 32') provided with electric fans if necessary to extract air from said cooling chambers (CA); - an upper wall (427) fixed to the top of said uprights (327, 327'), counter to the base structure (127), provided with a horizontal walkable intermediate section and having a U-shaped transverse profile, so that its raised edges can be surmounted by the corresponding end edges bent downwards of covers of the ridge (26) on which said discharge chimneys (32, 32') are provided, said upper wall (427) being provided with an intermediate slot crossed sealingly by a bracket (30) of the life line; the same wall (427) is provided at the ends and on the centre line with holes crossed sealingly by screws (33, 33') integral with forks (133, 133') anchored to the upper part of said double T uprights (327, 327') and cross members (34, 34') which can be tightened to form a bridge between the consecutive covers (26) of the ridge, to lock them securely in position, are fixed to said screws (33, 33') by respective nuts; at the ends of said upper wall (427) of each bridge (27) small pantiles (527, 527') are obtained integrally by cutting and bending operations or are welded, said pantiles surmounting the upper ends of the pairs of profiles (1, 9) supporting the panels (FV) and being closed by insulation and sealing inserts (35, 35'); said pantiles (527, 527') are positioned above upper plates (23) connecting the panels (FV) to the ridge cover (24) and the area joining these components (427, 26, 527, 527', 35, 35') is closed sealingly by a course of putty or sealing agent (36) which prevents infiltrations of water both downwards and upwards.

10. Structure as claimed in claim 9), wherein the area between the base profiles (127) and the upper wall (427) of the bridges (27) is closed by transverse walls (627) to improve the walkability of said bridges (27) and to prevent the air flows coming from each cooling chamber (CA), which cross respective heat exchangers (31, 31') and which reach the upper chambers (CR, CR'), from interfering with one another.
